(19) Europäisches Patentamt
European Patent Office
Office européen des brevets

(11) **EP 1 710 916 B1**

(12) **FASCICULE DE BREVET EUROPEEN**

(45) Date de publication et mention
de la délivrance du brevet:
**27.08.2008 Bulletin 2008/35**

(51) Int Cl.:
***H03L 7/087*** *(2006.01)*

(21) Numéro de dépôt: **06290566.6**

(22) Date de dépôt: **06.04.2006**

(54) **Boucle à asservissement de phase**

Phasenregelschleife

Phase-locked loop

(84) Etats contractants désignés:
**DE FR GB IT**

(30) Priorité: **07.04.2005 FR 0503480**

(43) Date de publication de la demande:
**11.10.2006 Bulletin 2006/41**

(73) Titulaire: **STMICROELECTRONICS SA**
**92120 Montrouge (FR)**

(72) Inventeurs:
• **Badets, Franck**
  **38240 Meylan (FR)**
• **Belot, Didier**
  **38140 Rives (FR)**
• **Lagareste, Vincent**
  **38190 Brignoud (FR)**
• **Deval, Yann**
  **33800 Bordeaux (FR)**

• **Melchior, Pierre**
  **33510 Andernos (FR)**
• **Begueret, Jean-Baptiste**
  **33400 Talence (FR)**

(74) Mandataire: **Verdure, Stéphane**
  **Cabinet Plasseraud**
  **52 rue de la Victoire**
  **75440 Paris Cedex 09 (FR)**

(56) Documents cités:
**GB-A- 1 526 928**      **US-A- 4 928 075**
**US-A- 6 097 777**

• **HERZEL F ET AL: "AN INTEGRATED CMOS RF SYNTHESIZER FOR 802.11A WIRELESS LAN" IEEE JOURNAL OF SOLID-STATE CIRCUITS, IEEE INC. NEW YORK, US, vol. 38, no. 10, octobre 2003 (2003-10), pages 1767-1770, XP001221449 ISSN: 0018-9200**

**EP 1 710 916 B1**

**Description**

La présente invention concerne les boucles à asservissement de phase (PLL, "Phase-Locked Loop"). Elle trouve des applications, en particulier, dans les synthétiseurs de fréquence utilisés, par exemple, dans les émetteurs et/ou récepteurs radiofréquence (RF).

Une PLL comprend classiquement un oscillateur commandé en tension (VCO, "Voltage-Controlled Oscillator") délivrant un signal à haute fréquence, un diviseur de fréquence (aussi appelé diviseur de boucle) convertissant le signal à haute fréquence en un signal à fréquence divisée, un comparateur de phase produisant un signal de mesure d'un écart de phase entre le signal à fréquence divisée et un signal de référence à une fréquence de référence, et un filtre passe-bas (aussi appelé filtre de boucle) auquel est appliqué le signal de mesure et dont la sortie commande le VCO.

Dans l'application à la synthèse de fréquence, on adapte la valeur du facteur de division appliqué par le diviseur de fréquence afin d'obtenir une valeur de consigne de la fréquence du signal de sortie du VCO. En effet, on a la relation suivante :

$$Fout = N \times Fref \qquad\qquad\qquad (1)$$

où Fout est la fréquence du signal de sortie du VCO ;
où Fref est la fréquence de référence de la PLL ; et,
où N est le support de division (entier) du diviseur de boucle.

La bande passante de la PLL correspond à celle d'un filtre passe-bas. Elle détermine la rapidité de la réponse à une modification de la consigne. Il s'agit d'un élément important des performances du synthétiseur incorporant cette PLL. En effet, plus la bande passante de la PLL est grande, et plus la stabilisation de la fréquence synthétisée est rapide, lors d'un changement de canal radio, par exemple.

De plus, la bande passante impose le suivi du bruit de phase de la source du signal de référence (qui est souvent meilleur que le bruit de phase du VCO en basses fréquences) dans cette bande de fréquence. Par conséquent, plus la bande passante est grande, plus la PLL, et donc le synthétiseur, ont un bruit de phase faible en basses fréquences.

C'est pourquoi il est souhaitable d'élargir la bande passante de la PLL, pour optimiser la rapidité et réduire le bruit de phase du synthétiseur de fréquence l'incorporant.

La bande passante de la PLL est essentiellement déterminée par la bande passante du filtre de boucle et par le gain en boucle ouverte de la PLL. Or, la bande passante du filtre de boucle est choisie de manière à filtrer la raie parasite ("spurious") générée par le comparateur de phase à la fréquence de référence.

Pour assurer la stabilité de la boucle, il convient de prendre pour le filtre de boucle une bande passante égale ou inférieure à $\dfrac{Fref}{10}$, voire $\dfrac{Fref}{15}$.

Le respect de ce critère assure une bonne stabilité et une bonne réjection de la raie parasite à Fref générée par le comparateur de phase.

La bande passante de la PLL dépend donc directement de la fréquence de référence Fref de la PLL. Plus la fréquence Fref est élevée, plus cette bande passante est large. Mais la fréquence de référence définit aussi le pas de synthèse, c'est-à-dire, par exemple, l'intervalle de fréquence séparant deux canaux radio adjacents (par exemple, 200 kHz pour le GSM). La bande passante de la PLL dépend donc de la fréquence de référence, qui elle-même dépend des standards visés (par le biais du pas de synthèse).

Dans l'art antérieur, on a déjà proposé une solution pour augmenter Fref sans nuire au pas de synthèse. Il s'agit de la PLL fractionnaire (i.e., non entière).

La PLL fractionnaire s'inscrit comme un compromis, par le remplacement du diviseur de fréquence à rapport de division entier par un diviseur de fréquence fractionnaire (division non entière). On peut ainsi augmenter la fréquence de référence (par exemple de 200 kHz à 10 MHz) tout en gardant le même pas de synthèse (200 kHz dans l'exemple).

Une PLL fractionnaire utilise un diviseur de boucle fractionnaire, basé sur l'emploi d'un modulateur Sigma-Delta dont la sortie pilote l'entrée de commande du rapport de division du diviseur. Un tel diviseur fractionnaire divise par N pendant un nombre déterminé P-1 de cycles du signal de référence et par N+1 pendant un cycle du signal de référence. On obtient alors, en moyenne, la relation suivante:

$$Fout = Fref \times \left( N + \frac{1}{P} \right) \qquad (2)$$

Le pas de synthèse devient inférieur à la fréquence de référence, puisqu'il est environ égal à $Fref \times \left( \frac{1}{P^2} \right)$.

Pour un pas de synthèse identique, on peut ainsi utiliser une fréquence de référence supérieure, ce qui permet aussi, par conséquent, d'augmenter la bande passante de la PLL.

Cette fréquence est toutefois obtenue uniquement en moyenne, sur N périodes du signal de référence, ce qui a pour conséquence directe de faire apparaître des raies parasites en sortie. Ces raies parasites limitent la bande passante utilisable de la PLL fractionnaire. Certes, le modulateur Sigma-Delta met en forme le bruit dans les hautes fréquences, mais on est tout de même obligé de baisser la fréquence de coupure du filtre de boucle pour le filtrer.

Pour cette raison, la PLL fractionnaire n'est pas entièrement satisfaisante du point de vue du problème posé.

Le document GB 1 526 928 décrit une PLL composite utilisant un discriminateur de fréquence supplémentaire suivi d'un filtre passe-bande pour corriger les variations rapides de fréquence dont on ne tient pas compte dans la boucle principale de la PLL.

C'est pourquoi, il est proposé d'augmenter la bande passante du filtre de boucle de la PLL tout en conservant la même réjection de la raie parasite générée par le comparateur de phase à la fréquence de référence.

L'invention s'applique ainsi à une boucle à asservissement de phase (PLL), comprenant un oscillateur commandé (par exemple un VCO) pour délivrer un signal de sortie à une fréquence de sortie déterminée, et un diviseur de fréquence (par exemple un diviseur de fréquence variable) pour convertir le signal de sortie en un signal à fréquence divisée. La PLL comprend au moins une première boucle ayant un filtre de boucle pour générer un premier signal de commande de l'oscillateur à partir du signal à fréquence divisée, et une seconde boucle ayant un filtre de boucle, distinct du filtre de boucle de ladite première boucle, pour générer, à partir du signal à fréquence divisée, un second signal de commande additionnelle de l'oscillateur. Le filtre de boucle de ladite première boucle et le filtre de boucle de ladite seconde boucle ont des fréquences de coupure respectives distinctes.

On notera que les deux boucles peuvent être actives simultanément, chacune apportant une contribution au filtrage du bruit de phase de l'oscillateur commandé. En effet, les effets du premier et du second signal de commande du VCO sont cumulés. C'est en ce sens que le second signal de commande est dit signal de commande additionnelle.

Une telle PLL est appelée PLL composite. La bande passante de la première boucle, ou boucle principale, peut être adaptée pour assurer la convergence et la stabilité de la PLL, alors que la seconde boucle, ou boucle secondaire, peut apporter un complément de bande passante. Bien entendu, l'invention n'est pas limitée par le nombre de boucles, qui peut être supérieur à deux.

Dans un premier mode de réalisation, la première boucle comprend un premier comparateur de phase pour produire un premier signal de mesure d'un écart de phase entre le signal à fréquence divisée, d'une part, et un premier signal de référence à une première fréquence de référence déterminée, d'autre part; et la seconde boucle comprend un second comparateur de phase pour produire un second signal de mesure d'un écart de phase entre un signal obtenu par multiplication de fréquence à partir du signal à fréquence divisée, d'une part, et un premier signal de référence à une seconde fréquence de référence déterminée, différente de, et supérieure à la première fréquence de référence, d'autre part. Ce mode de réalisation permet de faire fonctionner la seconde boucle à une fréquence supérieure à la fréquence de référence de la première boucle. On peut ainsi corriger des variations de phase du signal de sortie supérieures à cette fréquence.

Dans un deuxième mode de réalisation, conforme à la revendication 1, la première boucle est identique à celle du premier mode de réalisation et la seconde boucle comprend un comparateur de fréquence pour produire un second signal de mesure d'un écart de fréquence entre un signal à partir du signal à fréquence divisée, d'une part, et un premier signal de référence à une seconde fréquence de référence déterminée, différente de, et notamment supérieure à la première fréquence de référence, d'autre part. On peut ainsi corriger des variations de fréquence du signal de sortie supérieures à la première fréquence de référence.

De préférence, pour le premier et le deuxième modes de réalisation ci-dessus le filtre de boucle de la première boucle est un filtre passe-bas dont la fréquence de coupure est inférieure à la première fréquence de référence, et le filtre de boucle de la seconde boucle est un filtre passe-bande centré entre la première fréquence de référence, d'une part, et la seconde fréquence de référence, d'autre part, et qui a une fréquence de coupure basse supérieure à la première fréquence de référence et une fréquence de coupure haute inférieure à la seconde fréquence de référence. On assure ainsi la réjection de chacune des fréquences de références de la première et de la seconde boucle.

Avantageusement, la PLL peut comprendre en outre un multiplieur de fréquence par M ayant une entrée recevant le signal à fréquence divisée et une sortie couplée en entrée du second comparateur de phase, où M est le rapport de la fréquence du second signal de référence sur la fréquence du premier signal de référence. On n'a alors besoin que d'un diviseur de fréquence (le diviseur de boucle) et, surtout, les signaux obtenus à partir du signal de sortie qui sont fournis en entrée des comparateurs de phase, et du comparateur de fréquence pour le deuxième mode de réalisation, sont synchrones.

On peut aussi prévoir des moyens, tels qu'un interrupteur commandé, pour désactiver temporairement la seconde boucle, par exemple à la mise sous tension et/ou en cas de changement de la valeur de consigne pour la fréquence de sortie. Ceci permet d'assurer la stabilité de la PLL avant de mettre en service la seconde boucle, dont l'effet peut contrarier celui de la première boucle.

Un autre aspect de l'invention propose un synthétiseur de fréquence comprenant une boucle à asservissement de phase et de fréquence selon l'un des modes de réalisation décrits ci-dessus.

D'autres caractéristiques et avantages de l'invention apparaîtront encore à la lecture de la description qui va suivre. Celle-ci est purement illustrative et doit être lue en regard des dessins annexés sur lesquels :

- la figure 1 est un schéma d'une PLL selon l'art antérieur ;

- la figure 2 est un schéma d'un premier exemple de réalisation d'une PLL composite ;

- la figure 3 est un schéma d'un deuxième mode de réalisation d'une PLL composite ;

- la figure 4 donne le graphe de la réponse en fréquence (gain en fonction de la fréquence) de la PLL composite de la figure 2 ou de la PLL de la figure 3 ;

- la figure 5 est un schéma d'un premier mode de réalisation d'une PLL composite selon le premier aspect de l'invention ;

- la figure 6 est un schéma d'un deuxième mode de réalisation d'une PLL composite selon le premier aspect de l'invention ;

- la figure 7 donne le graphe de la réponse en fréquence (gain en fonction de la fréquence) de la PLL composite de la figure 5 ;

- la figure 8 est un schéma d'un synthétiseur de fréquence selon le second aspect de l'invention.

Sauf mention contraire, dans les dessins, des éléments identiques ou similaires portent des références identiques à travers toutes les figures.

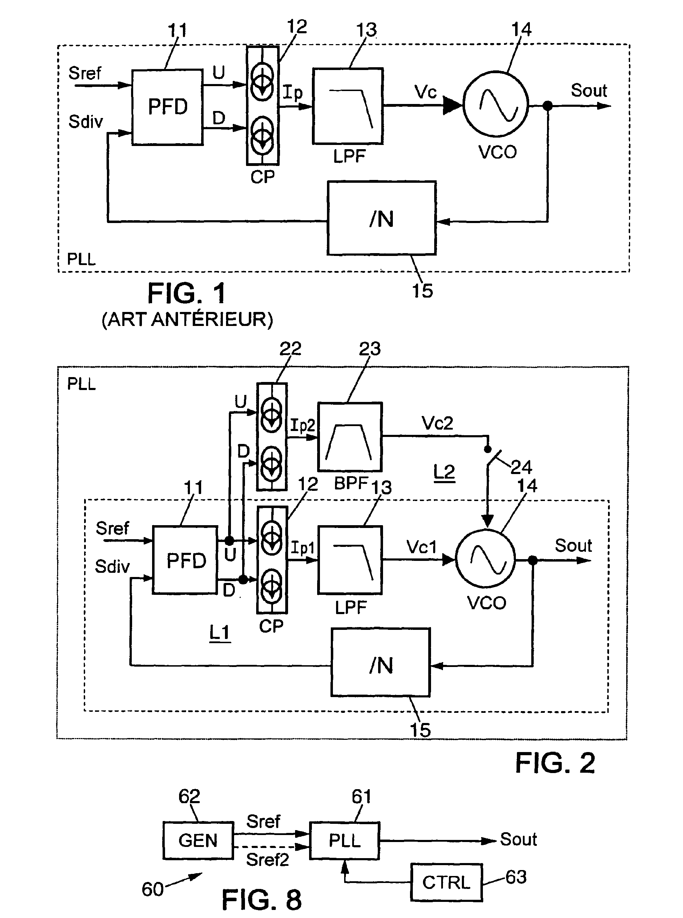

En référence à la figure 1, une PLL utilisée dans un synthétiseur de fréquence selon l'art antérieur comprend un VCO 14 délivrant un signal radiofréquence Sout, dont la fréquence Fout est par exemple de l'ordre de quelques centaines de MHz. Ce signal est adressé à un diviseur de fréquence 15 appliquant un rapport de division N variable. En modifiant N, on change la fréquence du signal de sortie Sout.

Le rapport de division du diviseur de fréquence peut être un nombre entier déterminé, c'est-à-dire que la PLL peut être une PLL entière. En variante, il peut s'agir d'une PLL fractionnaire, du type décrit en introduction.

Dans l'exemple considéré, la PLL est une PLL à pompe de charges (CP-PLL), qui est l'une des structures de PLL les plus utilisées. Dans une telle PLL, un comparateur de phase comprend un détecteur de phase/fréquence (PFD, "Phase Frequency Detector") délivrant deux signaux numériques binaires, suivi d'une pompe de charges (CP, "Charge Pump") assurant la conversion de ces signaux en un signal analogique qui facilite la réalisation des filtres de boucle.

Ici, le signal Sdiv à fréquence divisée qui est issu du diviseur de fréquence 15, est adressé à une entrée d'un PFD 11 qui reçoit en outre un signal de référence Sref produit à partir d'un oscillateur à cristal. La fréquence Fref du signal Sref est par exemple de l'ordre de la dizaine de MHz. Pour obtenir une fréquence déterminée Fvco en sortie du VCO 14, on prend N = Fout/Fref.

Le PFD 11 délivre en sortie deux signaux numériques binaires, U et D. Une pompe de charges 12 (CP, "Charge Pump") reçoit ces deux signaux pour établir un courant de charge Ip à un noeud d'entrée d'un filtre passe-bas 13 (LPF, "Low-Pass Filter") ayant une fréquence de coupure Fc1. Le courant Ip constitue un signal de mesure de l'écart de phase/fréquence entre les signaux Sdiv et Sref. La tension filtrée Vc produite par le filtre 13 à partir du courant IP est utilisée pour commander la fréquence du VCO 14.

Le schéma de la figure 2 illustre un premier exemple de réalisation d'une PLL composite.

Dans ce premier exemple de réalisation, la PLL comprend une première boucle L1, ou boucle principale, qui correspond à la PLL de la figure 1 (et est représentée dans le cadre en traits pointillés). Le signal de détection généré par la pompe de charges 12, est ici noté Ip1. De même, le signal de commande du VCO délivré par le filtre passe-bas 13 est ici noté Vc1.

La PLL de la figure 2 comprend en outre une seconde boucle L2, ou boucle secondaire. C'est pourquoi le VCO 14 comprend deux entrées de commande, qui sont par exemple respectivement couplées à des condensateurs variables (non représentés) internes au VCO, pour recevoir des signaux de commande respectivement associés à chacune des deux boucles. Les effets respectifs de ces deux signaux de commande sur la phase/fréquence du signal de sortie Sout sont cumulatifs.

En plus du VCO 14, du diviseur de fréquence 15 et du PFD 11, la boucle L2 comprend ici une autre pompe de charges 22, qui reçoit en entrée les signaux numériques binaires U et D délivrés par le PFD 11, et délivre en sortie un signal de détection Ip2. La boucle L2 comprend aussi un autre filtre 23, qui est de préférence un filtre passe-bande (BPF, "Bandpass Filter"), ayant une fréquence de coupure basse Fc21 et une fréquence de coupure haute Fc22. Ce filtre reçoit le signal de détection Ip2 en entrée. La tension filtrée Vc2 produite par ce filtre 23 à partir du signal Ip2 est utilisée, en combinaison avec la tension Vc1 produite par le filtre 13, en tant que signal de commande pour commander la fréquence d'oscillation du VCO 14.

Le fait de prévoir deux pompes de charges distinctes, une pour chaque boucle, alors qu'un seul PFD est utilisé, permet de contrôler le gain de boucle ouverte de chaque boucle indépendamment de l'autre. En effet, s'il n'y avait qu'une seule pompe de charges, d'une part son courant de sortie serait partagé entre les deux filtres 13 et 23 en proportion inverse de leur impédance d'entrée respective, qui est mal maîtrisée, et d'autre part la seule façon de contrôler le gain en boucle ouverte de chaque boucle serait de contrôler les gains de conversion tension/fréquence respectivement associés aux deux entrées de commande du VCO 14. Cela rendrait la stabilité plus difficile à contrôler car il y aurait un degré de liberté en moins.

En notant Kvco1 et Kvco2 ces gains, la fréquence Fout du signal Sout en sortie du VCO 14 est donnée par la relation suivante :

$$\text{Fvco} = \text{Kvco1} \times \text{Vc1} + \text{Kvco2} \times \text{Vc2} \tag{3}$$

Dans l'exemple considéré ici, la rapidité de convergence et la stabilité de la PLL sont déterminées principalement par la boucle principale L1. Par contre, la boucle secondaire permet de réduire le bruit de phase en sortie de la PLL par rapport à une autre PLL de l'art antérieur. En choisissant judicieusement les coefficients Kvco1 et Kvco2, il est possible de donner plus ou moins de poids à l'une des deux boucles par rapport à l'autre. De préférence, on veille à ne pas donner plus de poids à la boucle secondaire qu'à la boucle principale, afin de ne pas risquer de déstabiliser la PLL.

A la mise sous tension, et également à chaque modification de la valeur de consigne pour la fréquence Fout, les deux boucles L1 et L2 peuvent entrer en conflit lorsque l'effet de l'une vient contrarier l'effet de l'autre. La boucle principale L1 ayant pour rôle d'assurer la convergence et la stabilité de la PLL, la boucle secondaire L2 peut avantageusement n'être activée qu'après le verrouillage de la boucle principale L1.

A cet effet, un interrupteur 24 commandé numériquement, ou tout moyen similaire, peut être placé dans la boucle secondaire L2 pour désactiver temporairement la boucle L2, par exemple à la mise sous tension et/ou après chaque changement de la valeur de consigne pour la fréquence de sortie Fout (par exemple pour un changement de canal radio) correspondant à un changement de la valeur de N. Lorsque l'interrupteur 24 est fermé, les deux boucles L1 et L2 fonctionnent simultanément, et leurs effets respectifs sur le filtrage du bruit de phase du VCO 14 s'ajoutent.

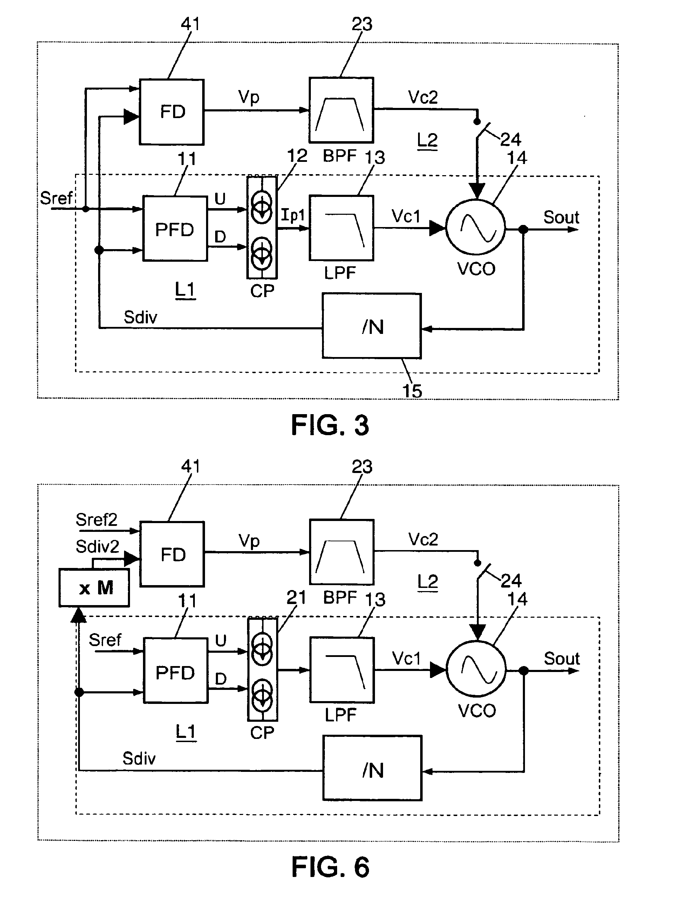

En référence à la figure 3, on peut remplacer le comparateur de phase/fréquence de la boucle L2 (lequel comprend le PFD 11 et la pompe de charges 22), par un détecteur de fréquence 41. Cette différence implique un comportement complètement différent pour la PLL. Un détecteur de phase donne une erreur lorsque les deux signaux comparés ne sont pas en phase. Plus particulièrement, il génère un signal d'erreur en sorte proportionnel à l'erreur de phase entre les deux signaux. Un détecteur de fréquence ne génère pas de signal d'erreur en sortie dans ce cas. A l'inverse, lorsque les deux signaux à comparer sont en phase mais de fréquence différente, le détecteur de fréquence génère un signal d'erreur en sortie. Dans les deux cas ci-dessus, un détecteur de phase/fréquence, tel que le PFD 11, génère un signal d'erreur en sortie.

Si l'on considère que la boucle principale (boucle L1, par exemple à basse fréquence) est verrouillée, cela veut dire que les variations de phase/fréquence sont faibles. Ces variations peuvent être interprétées de deux manières : comme des variations de phase ou comme des variations de fréquence. Dit autrement, on peut voir le bruit sur le signal à fréquence divisée Sdiv comme un bruit en fréquence en supposant que la boucle principale L1 asservit la phase/fréquence du signal de sortie Sout au signal de référence Sref par l'intermédiaire du détecteur de phase/fréquence 11. C'est pourquoi le mode de réalisation de la figure 3 est proposé.

Ce mode de réalisation est identique à celui de la figure 2 sauf en ce que, pour la boucle secondaire L2, le détecteur de fréquence 41 reçoit le signal à fréquence divisée Sdiv sur une première entrée, reçoit le signal de référence Sref sur une seconde entrée délivre en sortie un signal de mesure de l'écart de phase/fréquence Vp. Le filtre 23 génère le second signal de commande Vc2 en sortie, à partir de ce signal Vp reçu en entrée.

Le fait d'utiliser un détecteur de fréquence dans la boucle L2 facilite la conception de la PLL. En effet, comme il y a une relation d'intégration (par rapport au temps) entre la phase et la fréquence, il n'y a plus besoin de modéliser le VCO par un intégrateur (pas besoin de conversion fréquence/phase). On peut le modéliser par un simple gain (en Hz/V). Donc on n'a pas à prévoir un gain supplémentaire dans la boucle L2 pour compenser l'atténuation apportée par cet intégrateur.

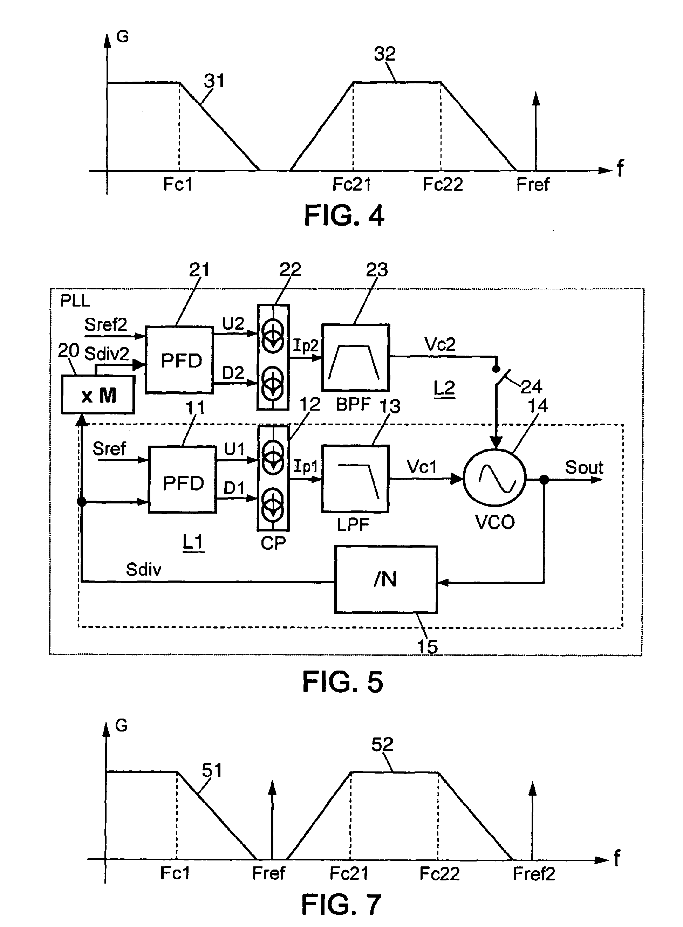

A la figure 4, on a représenté un exemple de graphe de la réponse en fréquence (gain en fonction de la fréquence) de la PLL composite de la figure 2 ou de la figure 3. Sur ce graphe, on peut distinguer la contribution au filtrage apportée par la boucle L1, qui correspond au gabarit 31 d'un filtre passe-bas, de la contribution au filtrage apportée par la boucle L2, qui correspond au gabarit 32 d'un filtre passe-bande.

Le gabarit 31 est essentiellement déterminé par la bande passante du filtre de boucle 13 de la boucle L1, alors que le gabarit 32 est essentiellement déterminé par la bande passante du filtre de boucle 23 de la boucle L2.

Plus particulièrement, le filtre de boucle 13 de la boucle L1, qui est un filtre passe-bas, a une fréquence de coupure Fc1 inférieure à la fréquence de référence Fref. Le filtre de boucle 23 de la boucle L2, qui est un filtre passe-bande, est centré entre la fréquence de coupure Fc1 du filtre de boucle 13 de la boucle L1, d'une part, et la fréquence de référence Fref de la PLL, d'autre part. Par exemple, il a une fréquence de coupure basse Fc21 supérieure à la fréquence de coupure Fc1 du filtre de boucle 13 de la boucle L1 et une fréquence de coupure haute Fc22 inférieure à la fréquence de référence Fref.

Typiquement, on choisira Fc1 de telle manière que la boucle L1 assure la stabilité de la PLL, par exemple avec Fc1 inférieure à $\dfrac{Fref}{100}$, selon les applications. De plus, on choisira Fc22 telle que la boucle L2 assure une bonne réjection de la fréquence Fref, par exemple avec Fc22 inférieure à $\dfrac{Fref}{10}$, voire à $\dfrac{Fref}{15}$. Ainsi, la réponse en fréquence de la boucle L2 permet d'augmenter la bande passante de la PLL composite sans menacer sa stabilité, et tout en maintenant une bonne réjection de la raie parasite à la fréquence Fref.

La boucle secondaire L2 a pour effet de prendre en compte les variations de phase à hautes fréquences (par rapport à la boucle principale L1). Dit autrement, les erreurs de phase à hautes fréquences qui n'ont pas été prises en compte par la boucle principale L1 sont corrigées par la boucle secondaire L2.

Cependant, on notera que les fréquences de variation de phase pouvant être compensées par la boucle secondaire L2 sont dépendantes de la fréquence de référence Fref. En effet, les informations de phase du VCO 14 observées à travers le diviseur de fréquence 15 ne sont rafraîchies qu'à la fréquence de référence Fref (il y a une nouvelle comparaison à chaque cycle du signal de référence Fref). Par conséquent, on ne peut corriger que des fréquences de variation de phase inférieures à la fréquence de référence Fref divisée par deux.

La boucle secondaire L2 des PLL composites selon les figures 2 et 4 présente d'autant plus d'intérêt que la boucle principale L1 a une faible bande passante [0-Fc1] et une fréquence de référence Fref élevée. Ce cas de figure peut se rencontrer, par exemple, pour une synthèse de fréquence avec une boucle à translation de fréquence où cette architecture est particulièrement adaptée.

Mais cela n'est pas le cas de toutes les synthèses de fréquence. C'est pour cette raison qu'il est aussi proposé deux architectures de PLL composites alternatives à celles qui ont été présentées ci-dessus en regard des schémas de la figure 2 et de la figure 3, respectivement.

Un premier mode de réalisation de la PLL composite selon l'invention est ainsi illustré par le schéma de la figure 5. Il se distingue de celui de la figure 2 par la présence d'un comparateur de phase/fréquence pour chacune des boucles L1 et L2. Dit autrement, au lieu d'avoir un comparateur de phase commun aux deux boucles, comme dans le cas de la figure 2, la PLL composite a ici un comparateur de phase/fréquence pour chaque boucle, fonctionnant chacun à une fréquence de référence respectivement Fref et Fref2 qui lui est propre. En particulier, la fréquence de référence Fref2 de la boucle L2 est supérieure à la fréquence de référence Fref de la boucle L1.

Dans un exemple, Fref2 est M fois plus grande que Fref, où M est un nombre entier déterminé. Avantageusement, des signaux de référence Sref et Sref2 aux fréquences de référence respectivement Fref et Fref2, sont obtenus par division de fréquence du signal d'oscillation d'un même oscillateur à cristal, le signal Sref étant obtenu à partir du signal de Sref2 via un diviseur de fréquence par M supplémentaire.

Egalement, la PLL composite de la figure 5 comprend un multiplieur de fréquence par M, référencé 20, par exemple dans la boucle secondaire L2, pour produire un signal Sdiv2 à partir du signal Sdiv.

Le comparateur de phase/fréquence de la boucle L1 comprend le PFD 11, recevant le signal Sdiv (généré par le diviseur de fréquence 15 à partir du signal de sortie Sout) et le signal Sref en entrée, et délivrant en sortie des signaux numériques binaires notés ici U1 et D1. Le PFD 11 est suivi de la pompe de charge 12, qui délivre le signal analogique de détection Ip1 à partir des signaux U1 et D1.

Le comparateur de phase/fréquence de la boucle L2 comprend un autre PFD 21, recevant un signal Sdiv2 (généré par le multiplieur de fréquence 20 à partir du signal Sdiv) et le signal Sref2 en entrée, et délivrant en sortie des signaux numériques binaires notés ici U2 et D2. Le PFD 21 est suivi de la pompe de charge 22, qui délivre le signal analogique de détection Ip2 à partir des signaux U2 et D2.

Un deuxième mode de réalisation selon l'invention, illustré par le schéma de la figure 6, est une combinaison des autres modes de réalisation, précédemment décrits en référence aux figures 3 et 5, respectivement.

A la figure 7, on a représenté un exemple de graphe de la réponse en fréquence de la PLL composite de la figure 5 ou de la figure 6. Sur ce graphe, on peut distinguer la contribution au filtrage apportée par la boucle L1, qui correspond au gabarit 51 d'un filtre passe-bas, de la contribution au filtrage apportée par la boucle L2, qui correspond au gabarit 52 d'un filtre passe-bande.

Avec les mêmes notations que celles utilisées plus haut en référence à la figure 4, le filtre de boucle 13 de la boucle L1, qui est un filtre passe-bas, a une fréquence de coupure Fc1 inférieure à la fréquence de référence Fref. Le filtre de boucle 23 de la boucle L2, qui est un filtre passe-bande, est centré entre la fréquence de référence Fref de la boucle L1, d'une part, et la fréquence de référence Fref2 de la boucle L2, d'autre part. Par exemple, sa fréquence de coupure basse Fc21 est supérieure à la fréquence Fref et sa fréquence de coupure haute Fc22 est inférieure à la fréquence Fref2.

Typiquement, on choisira toujours Fc1 de telle manière que la boucle L1 assure la stabilité de la PLL, par exemple avec Fc1 inférieure à $\dfrac{Fref}{10}$ voire à $\dfrac{Fref}{15}$, selon les applications. De plus, on choisira Fc21 et Fc22 telles que la boucle L2 assure une bonne réjection des fréquences Fref et Fref2, par exemple avec Fc21 supérieure à $10 \times$ Fref voire à 15xFref, et avec Fc22 inférieure à $\dfrac{Fref2}{10}$, voire à $\dfrac{Fref2}{15}$. Ainsi, la réponse en fréquence de la boucle L2 permet ici encore d'augmenter la bande passante de la PLL composite sans menacer sa stabilité, et tout en maintenant une bonne réjection des raies parasites à la fréquence Fref1 et à la fréquence Fref2.

Le premier et le deuxième modes de réalisation décrits ci-dessus permettent à la boucle secondaire L2 de fonctionner à une fréquence de référence Fref2 supérieure à celle de la boucle principale L1, et ainsi d'augmenter les fréquences de variation de phase du signal de sortie Sout pouvant être corrigées.

Ces premier et deuxième modes de réalisation selon l'invention ont donc pour principal avantage de palier les inconvénients précités de l'architecture correspondant aux autres modes de réalisation d'une PLL composite, mais au prix d'une complexité accrue.

Un autre aspect de l'invention, illustré par le schéma de la figure 8, se rapporte à un synthétiseur de fréquence 60 comprenant une PLL composite 61 selon l'un des modes de réalisation décrit ci-dessus, pour générer un signal de sortie Sout.

De façon connue en soi, un tel synthétiseur comprend un générateur d'horloges 61 ayant un oscillateur, tel qu'un oscillateur à cristal, ainsi qu'un (ou plusieurs) diviseur(s) de fréquence pour générer le signal (ou les signaux) de référence Sref et Sref2.

Il comprend aussi une unité 63 de commande du facteur de division N du diviseur de la PLL, en fonction des besoins de l'application.

**Revendications**

1. Boucle à asservissement de phase comprenant un oscillateur commandé (14) pour délivrer un signal de sortie (Sout) à une fréquence de sortie (Fout) déterminée, et un diviseur de fréquence (15) pour convertir le signal de sortie en un signal (Sdiv) à fréquence divisée, comprenant au moins:

   - une première boucle (L1) ayant un filtre de boucle (13) pour générer un premier signal (Vc1) de commande de l'oscillateur à partir du signal à fréquence divisée; et,
   - une seconde boucle (L2) ayant un filtre de boucle (23), distinct du filtre de boucle de ladite première boucle, pour générer, à partir du signal à fréquence divisée, un second signal (Vc2) de commande additionnelle de l'oscillateur;

et dans laquelle le filtre de boucle de ladite première boucle et le filtre de boucle de ladite seconde boucle ont des fréquences de coupure respectives distinctes,
**caractérisé en ce que**:

- la première boucle comprend un comparateur de phase/fréquence (11,12, figure 6) pour produire un premier signal (Ip1) de mesure d'un écart de phase/fréquence entre le signal à fréquence divisée, d'une part, et un premier signal de référence (Sref) à une première fréquence de référence (Fref) déterminée, d'autre part; et
- la seconde boucle comprend un comparateur de fréquence (41, figure 6) pour produire un second signal (Ip2) de mesure d'un écart de fréquence entre un signal (Sdiv2) obtenu par multiplication de fréquence à partir du signal à fréquence divisée, d'une part, et un second signal de référence (Sref2) à une seconde fréquence de référence (Fref2) déterminée, supérieure à ladite première fréquence de référence, d'autre part.

2. Boucle à asservissement de phase selon la revendication 1, dans laquelle le filtre de boucle de la première boucle est un filtre passe-bas dont la fréquence de coupure (Fc1) est inférieure à la première fréquence de référence, et dans laquelle le filtre de boucle de la seconde boucle est un filtre passe-bande centré entre la première fréquence de référence, d'une part, et la seconde fréquence de référence, d'autre part, et qui a une fréquence de coupure basse (Fc21) supérieure à la première fréquence de référence et une fréquence de coupure haute (Fc22) inférieure à la seconde fréquence de référence.

3. Boucle à asservissement de phase selon l'une quelconque des revendications 1 et 2, comprenant un multiplieur de fréquence (20) par M ayant une entrée recevant le signal à fréquence divisée et une sortie couplée en entrée du second comparateur de phase/fréquence ou du détecteur de fréquence, où M est le rapport de la fréquence du second signal de référence sur la fréquence du premier signal de référence.

4. Boucle à asservissement de phase selon l'une quelconque des revendications précédentes, comprenant des moyens (24) pour désactiver temporairement la seconde boucle à la mise sous tension et/ou en cas de changement d'une consigne pour la fréquence de sortie.

5. Synthétiseur de fréquence comprenant une boucle à asservissement de phase selon l'une quelconque des revendications précédentes.

6. Appareil émetteur et/ou récepteur radiofréquence, comprenant un synthétiseur de fréquence selon la revendication 5.

**Claims**

1. Phase locked loop comprising a controlled oscillator (14) for delivering an output signal (Sout) at a determined output frequency (Fout), and a frequency divider (15) for converting the output signal into a signal (Sdiv) at divided frequency, comprising at least:

- a first loop (L1) having a loop filter (13) for generating a first signal (Vc1) for control of the oscillator on the basis of the signal at divided frequency; and,
- a second loop (L2) having a loop filter (23), different from the loop filter of the said first loop, for generating, on the basis of the signal at divided frequency, a second signal (Vc2) for additional control of the oscillator;

and wherein the loop filter of the said first loop and the loop filter of the said second loop have different respective cutoff frequencies,
**characterized in that**:

- the first loop comprises a phase/frequency comparator (11,12, Figure 6) for producing a first signal (lp1) of measurement of a phase/frequency deviation between the signal at divided frequency, on the one hand, and a first reference signal (Sref) at a first determined reference frequency (Fref), on the other hand; and
- the second loop comprises a frequency comparator (41, Figure 6) for producing a second signal (lp2) of measurement of a frequency deviation between a signal (Sdiv2) obtained by frequency multiplication on the basis of the signal at divided frequency, on the one hand, and a second reference signal (Sref2) at a second determined reference frequency (Fref2), higher than the said first reference frequency, on the other hand.

2. Phase locked loop according to Claim 1, wherein the loop filter of the first loop is a low-pass filter whose cutoff frequency (Fc1) is lower than the first reference frequency, and wherein the loop filter of the second loop is a bandpass filter centred between the first reference frequency, on the one hand, and the second reference frequency, on the other hand, and which has a low cutoff frequency (Fc21) higher than the first reference frequency and a high cutoff frequency (Fc22) lower than the second reference frequency.

3. Phase locked loop according to one any of Claims 1 and 2, comprising a frequency multiplier (20) multiplying by M having an input receiving the signal at divided frequency and an output coupled to the input of the second phase/ frequency comparator or of the frequency detector, where M is the ratio of the frequency of the second reference signal to the frequency of the first reference signal.

4. Phase locked loop according to any one of the preceding claims, comprising means (24) for temporarily deactivating the second loop on power-up and/or in case of change of a preset for the output frequency.

5. Frequency synthesizer comprising a phase locked loop according to any one of the preceding claims.

6. Radiofrequency transmitter and/or receiver apparatus, comprising a frequency synthesizer according to Claim 11.

**Patentansprüche**

1. Phasenregelschleife, umfassend einen gesteuerten Oszillator (14) zum Ausgeben eines Ausgangssignals (Sout) einer bestimmten Ausgangsfrequenz (Fout), und einen Frequenzteiler (15) zum Umwandeln des Ausgangssignals in ein Signal (Sdiv) geteilter Frequenz, zumindest umfassend:

    - eine erste Schleife (L1) mit einem Schleifenfilter (13) zum Erzeugen eines ersten Oszillatorsteuer-Signals (Vc1) auf der Grundlage des Signals geteilter Frequenz; und
    - eine zweite Schleife (L2) mit einem vom Schleifenfilter der ersten Schleife verschiedenen Schleifenfilter (23), um auf der Grundlage des Signals geteilter Frequenz ein zweites zusätzliches Oszillatorsteuer-Signal (Vc2) zu erzeugen;

und in der das Schleifenfilter der ersten Schleife und das Schleifenfilter der zweiten Schleife verschiedene jeweilige Grenzfrequenzen aufweisen;
**dadurch gekennzeichnet, dass**:

    - die erste Schleife einen Phasen-/FrequenzKomparator (11, 12, Figur 6) zum Erzeugen eines ersten Mess-Signals (lp1) einer Abweichung der Phase/Frequenz zwischen dem Signal bei geteilter Frequenz und einem ersten Referenzsignal (Sref) bei einer ersten, bestimmten Referenzfrequenz (Fref) umfasst; und
    - die zweite Schleife einen Frequenzkomparator (41, Figur 6) zum Erzeugen eines zweiten Mess-Signals (lp2) einer Frequenzabweichung zwischen einem durch Frequenzmultiplikation auf der Grundlage des Signals geteilter Frequenz erhaltenen Signals (Sdiv2) und einem zweiten Referenzsignal (Sref2) einer zweiten, bestimmten Referenzfrequenz (Fref2), die höher ist als die erste Referenzfrequenz, umfasst.

2. Phasenregelschleife nach Patentanspruch 1, in der das Schleifenfilter der ersten Schleife ein Tiefpassfilter ist, dessen Grenzfrequenz (Fc1) niedriger ist als die erste Referenzfrequenz, und in der das Schleifenfilter der zweiten Schleife ein Bandpassfilter ist, das zwischen der ersten Referenzfrequenz und der zweiten Referenzfrequenz zentriert ist und das eine untere Grenzfrequenz (Fc21) aufweist, die höher ist als die erste Referenzfrequenz, und eine obere Grenzfrequenz (Fc22) aufweist, die niedriger ist als die zweite Referenzfrequenz.

3. Die Phasenregelschleife nach einem der Patentansprüche 1 und 2, umfassend einen Frequenzmultiplizierer (20) mit M, der einen das Signal geteilter Frequenz empfangenden Eingang und einen mit einem Eingang des zweiten Phasen-/Frequenz-Komparators oder des Frequenzdetektors gekoppelten Ausgang aufweist, wobei M das Verhältnis der Frequenz des zweiten Referenzsignals zur Frequenz des ersten Referenzsignals darstellt.

4. Die Phasenregelschleife nach einem der vorangehenden Patentansprüche, umfassend Mittel (24) zum vorübergehenden Deaktivieren der zweiten Schleife bei Spannungsanlegung und/oder im Falle der Änderung eines Sollwerts für die Ausgangsfrequenz.

5. Ein Frequenzsynthesizer, umfassend eine Phasenregelschleife nach einem der vorangehenden Patentansprüche.

6. Ein Funkfrequenz-Sendergerät und/oder ein Funkfrequenz-Empfangsgerät, umfassend einen Frequenzsynthesizer nach Patentanspruch 5.

FIG. 1
(ART ANTÉRIEUR)

FIG. 2

FIG. 8

**FIG. 4**

**FIG. 5**

**FIG. 7**

**FIG. 3**

**FIG. 6**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- GB 1526928 A